(19) Europäisches Patentamt
European Patent Office
Office européen des brevets

(11) **EP 0 763 830 B1**

(12) **EUROPÄISCHE PATENTSCHRIFT**

(45) Veröffentlichungstag und Bekanntmachung des Hinweises auf die Patenterteilung:
**14.11.2001 Patentblatt 2001/46**

(51) Int Cl.7: **G11C 17/12**

(21) Anmeldenummer: **96114002.7**

(22) Anmeldetag: **30.08.1996**

(54) **Speicherzellenanordnung aus matrixförmig angeordneten Speicherzellen**

Arrangement of memory cells in matrix form

Dispositif de cellules de mémoire en forme de réseau matriciel

(84) Benannte Vertragsstaaten:
**AT DE FR GB IE IT NL**

(30) Priorität: **13.09.1995 DE 19533951**

(43) Veröffentlichungstag der Anmeldung:
**19.03.1997 Patentblatt 1997/12**

(73) Patentinhaber: **Infineon Technologies AG**
**81669 München (DE)**

(72) Erfinder:
• **Von Basse, Paul-Werner**
**82515 Wolfratshausen (DE)**
• **Thewes, Roland, Dr.**
**82194 Gröbenzell (DE)**
• **Schmitt-Landsiedel, Doris, Dr.**
**85521 Ottobrunn (DE)**
• **Bollu, Michael, Dr.**
**81671 München (DE)**

(74) Vertreter: **Zedlitz, Peter, Dipl.-Inf. et al**
**Patentanwalt,**
**Postfach 22 13 17**
**80503 München (DE)**

(56) Entgegenhaltungen:
**EP-A- 0 102 485          EP-A- 0 424 964**

• **PATENT ABSTRACTS OF JAPAN vol. 005, no. 182 (P-090), 20. November 1981 & JP 56 111191 A (MATSUSHITA ELECTRIC IND CO LTD), 2. September 1981**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Speicherzellenanordnung nach dem Oberbegriff des Patentanspruchs 1.

In der älteren deutschen Patentanmeldung P 195 14 834.7 (GR 95 P 1329 DE) ist eine Speicherzellenanordnung der genannten Art vorgeschlagen, bei welcher die Bitleitungen einen so kleinen Abstand haben, daß zwar zwischen zwei Bitleitungen MOS-Transistoren plaziert werden können, aber an den Enden der Bitleitungen keine Transistoren mit einem Source- oder Drainanschluß an einer Vorladespannung nebeneinander liegend angeordnet werden können. Eine direkte Kontaktierung der Bitleitungen zu einer Verdrahtungsebene ist aus Platzgründen ebenfalls nicht möglich.

Zum Vorladen der Bitleitungen auf bestimmte Anfangspotentiale werden jedoch solche Anschlüsse benötigt. Wegen des engen Rasters können nur auf jeder zweiten Bitleitung parallel liegende Transistoren untergebracht werden. Um alle Bitleitungen zu erreichen, können die restlichen Bitleitungen am anderen Ende mit Transistoren versehen werden. Würden diese Transistoren ausschließlich zum Vorladen benutzt, wäre der Zugang zu den Bitleitungen für den Daten-Transfer versperrt. Vorladen und Daten-Transfer gemeinsam kann nur über eine komplizierte Schaltungsanordnung an den Enden der Bitleitungen realisiert werden.

Mit der im Anspruch 1 angegebenen Erfindung ist eine Anordnung der eingangs genannten Art bereitgestellt, bei welcher vorteilhafterweise ein Vorladen sämtlicher Bitleitungen ohne eine Versperrung der Zugangs zu den Bitleitungen, insbesondere zu deren Enden, ermöglicht ist.

Bevorzugte und vorteilhafte Ausgestaltungen der erfindungsgemäßen Anordnung gehen aus den Unteransprüchen hervor.

Die Erfindung wird in der nachfolgenden Beschreibung anhand der Figuren beispielhaft näher erläutert. Es zeigen:

Figur 1 ein Schaltbild, das einen Ausschnitt aus einer erfindungsgemäßen Speicheranordnung zeigt,

Figur 2 in stark vereinfachter Darstellung eine erfindungsgemäße Speicheranordnung mit mehreren Vorladeleitungen und Potentialleitungen, und

Figur 3 eine Speicheranordnung bisheriger Art, bei welcher an den Enden jeder zweiten Bitleitung parallel liegende Transistoren und an den diesen Enden gegenüberliegenden Enden der restlichen Bitleitungen ebenfalls parallel liegende Transistoren zum Vorladen angeordnet sind.

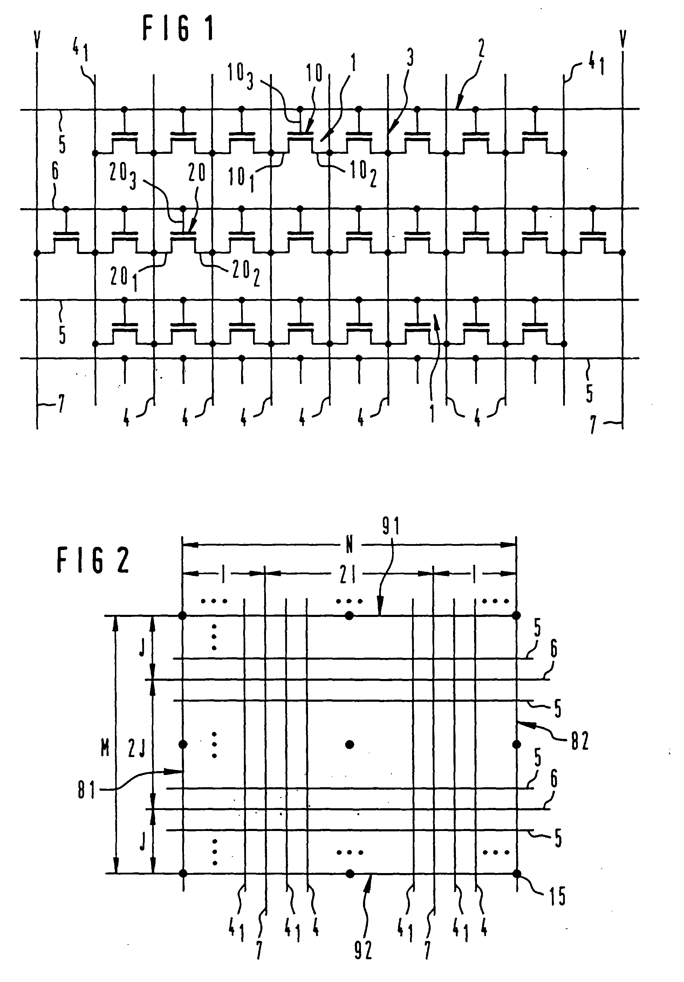

Die erfindungsgemäße Speicherzellenanordnung nach Figur 1 besteht aus matrixförmig in Zeilen 2 und Spalten 3 angeordneten Speicherzellen 1, deren jede einen MOS-Transistor 10 mit je einem Sourceanschluß $10_1$, Drainanschluß $10_2$ und Gateanschluß $10_3$ aufweist.

Jede Spalte 3 ist zwischen zwei benachbarten Bitleitungen 4, 4 oder 4, $4_1$ angeordnet. Ebensogut könnte jede Zeile 2 zwischen zwei benachbarten Bitleitungen 4, 4 oder 4, $4_1$ angeordnet sein.

Im erstgenannten Fall verläuft entlang jeder Zeile 2, im zweitgenannten Fall, bei dem die Spalten 3 durch die Zeilen 2 und die Zeilen 2 durch die Spalten 3 ersetzt sind, entlang jeder Spalte 3 je eine zugeordnete Auswahlleitung 5.

Die folgende Beschreibung bezieht sich auf den erstgenannten Fall, gilt jedoch sinngemäß auch für den zweitgenannten Fall.

Jeder Transistor 10 einer Spalte 3 ist über seinen Sourceanschluß $10_1$ und Drainanschluß $10_2$ an die diesem Transistor 10 benachbarten Bitleitungen 4, 4 oder 4, $4_1$ und jeder Transistor 10 einer Zeile 2 über seinen Gateanschluß $10_3$ an die diesem Transistor 10 zugeordnete Auswahlleitung 5 angeschlossen.

Erfindungsgemäß ist jeweils zwischen zwei benachbarten Bitleitungen 4, 4 oder 4, $4_1$ und zwischen zumindest einer bestimmten Bitleitung $4_1$ und einem bestimmten elektrischen Potential V je zumindest ein weiterer MOS-Transistor 20 mit jeweils einem Sourceanschluß $20_1$, Drainanschluß $20_2$ und Gateanschluß $20_3$ angeordnet, der über seinen Sourceanschluß $20_1$ und Drainanschluß $20_2$ an die diesem weiteren Transistor 20 benachbarten Bitleitungen 4, 4 oder 4, $4_1$ oder die bestimmte Bitleitung $4_1$ und das bestimmte Potential V angeschlossen ist.

Die Gateanschlüsse $20_3$ dieser weiteren MOS-Transistoren 20 sind an eine gemeinsame Vorladeleitung 6 zum wahlweisen Vorladen der Bitleitungen 4 und $4_1$ auf das bestimmte Potential V angeschlossen.

Das bestimmte Potential V liegt vorzugsweise an einer Potentialleitung 7, beispielsweise eine Versorgungsleitung, die neben der bestimmten Bitleitung $4_1$ verläuft. Bei später beschriebenen Ausführungsformen sind mehrere Bitleitungen 7 und/oder mehrere bestimmte Bitleitungen $4_1$ vorhanden denen eine oder zwei Potentialleitungen 7 benachbart ist/sind. Unter einer bestimmten Bitleitung $4_1$ ist eine Bitleitung 4 zu verstehen, der zumindest eine Potentialleitung 7 benachbart ist.

Die erfindungsgemäße Speicherzellenanordnung nach Figur 1 funktioniert beispielsweise folgendermaßen:

Alle Bitleitungen 4 und $4_1$ sowie alle Auswahlleitungen 5 und die Vorladeleitung 6 seien auf niedrigem Potential $V_0$, beispielsweise Masse. Nur die Potentialleitung 7, die neben der bestimmten Bitleitung $4_1$ verläuft, liege auf dem bestimmten, gegenüber dem niedrigen Potential $V_0$ beispielsweise höheren Potential V, welches z. B. die Versorgungsspannung der Anordnung ist. Sämtliche MOS-Transistoren 10 und weiteren MOS-Transistoren 20 seien unter diesen Umständen gesperrt.

Sobald die Vorladeleitung 6 vom niedrigen Potential $V_0$ auf das bestimmte höhere Potential V gebracht wird, werden alle weiteren Transistoren 20, deren Gateanschlüsse $20_3$ an diese Vorladeleitung 6 angeschlossen sind, leitend. Alle Bitleitungen 4 und $4_1$ sind durch die weiteren Transistoren 20 untereinander und außerdem mit der Potentialleitung 7 verbunden. Die Bitleitungen 4 und $4_1$ werden dadurch über die leitende Kette aus den weiteren Transistoren 20 von der Potentialleitung 7 aus auf das gewünschte bestimmte Potential V vorgeladen. Das gleiche gilt auch für einzelne Bitleitungen 4 oder $4_1$, die während des Lesevorgangs entladen wurden. Diese einzelnen Bitleitungen 4 oder $4_1$ beziehen ihre Ladung zum Teil auch von den benachbarten Bitleitungen 4 oder $4_1$.

Bei großen Feldern aus Speicherzellen 1 würde der Ladevorgang infolge hochohmiger Bitleitungen 4 und $4_1$ und hochohmiger Vorladeleitungen 6 sehr lange dauern. Diese Ladezeit kann wesentlich verkürzt werden,

- wenn zwei oder mehrere bestimmte Bitleitungen $4_1$ vorgesehen sind, deren jede über den Sourceanschluß $20_1$ und Drainanschluß $20_2$ je eines mit seinem Gateanschluß $20_3$ an die Vorladeleitung 6 angeschlossenen weiteren MOS-Transistors 20 an das bestimmte Potential V angeschlossen ist und/oder
- wenn zwei oder mehrere Vorladeleitungen 6 zum wahlweisen Vorladen der Bitleitungen 4 und $4_1$ auf das bestimmte Potential V vorgesehen sind, an deren jede weitere MOS-Transistoren 20 mit ihrem Gateanschluß $20_3$ angeschlossen sind, wobei jeder dieser weiteren Transistoren 20 zwischen zwei benachbarten Bitleitungen 4, 4 oder 4, $4_1$ oder zumindest einer bestimmten Bitleitung $4_1$ und dem bestimmten Potential V angeordnet ist und mit seinem Sourceanschluß $20_1$ und Drainanschluß $20_2$ an diese benachbarten Bitleitungen 4, 4 oder 4, $4_1$ oder diese bestimmte Bitleitung $4_1$ und das bestimmte Potential V angeschlossen ist.

Eine derartige Anordnung, bei der vorteilhafterweise beide Möglichkeiten realisiert sind, ist in der Figur 2 stark schematisiert dargestellt. In dieser Figur 2 sind im wesentlichen nur Paare einander gegenüberliegender Ränder 81, 82 und 91, 92 des Speicherzellenfeldes der erfindungsgemäßen Anordnung, einige Potentialleitungen 7, einige Bitleitungen 4 und bestimmte Bitleitungen $4_1$, einige Auswahlleitungen 5 sowie einige Vorladeleitungen 6 dargestellt. Die übrigen Potentialleitungen 7, Bitleitungen 4 und bestimmten Bitleitungen $4_1$, Auswahlleitungen 5 und Vorladeleitungen 6, soweit vorhanden, und die Transistoren 10 und weiteren Transistoren 20 sind fortgelassen.

Die Anordnung nach Figur 2 bestehe aus insgesamt N Bitleitungen 4 und $4_1$ und K Potentialleitungen 7, die in Zeilenrichtung nacheinander angeordnet sind, sowie aus M Auswahlleitungen 5 und L Vorladeleitungen 6, die Spaltenrichtung nacheinander angeordnet sind.

Die K Potentialleitungen 7 sind unter den Bitleitungen 4 bzw. $4_1$ und die L Vorladeleitungen 6 unter den M Auswahlleitungen 5 derart verteilt, daß

- zwischen jeweils einem - 81 oder 82 - von zwei einander gegenüberliegenden und jeweils quer zu den Auswahlleitungen 5 verlaufenden äußeren Rändern 81, 82 der Anordnung und jeweils einer diesem Rand 81 bzw. 82 nächstliegenden und in der Figur 2 dargestellten äußersten der K Potentialleitungen 7 jeweils I Bitleitungen 4, $4_1$ und
- zwischen jeweils einem - 91 oder 92 - von zwei einander gegenüberliegenden und jeweils längs der Auswahlleitungen 5 verlaufenden äußeren Rändern 91, 92 der Anordnung und jeweils einer diesem Rand 91 bzw. 92 nächstliegenden und in der Figur 2 dargestellten äußersten der L Vorladeleitungen 6 jeweils J Auswahlleitungen 5 liegen.

N, M, K und L sind jeweils natürliche Zahlen.
Eine für die Beschleunigung B des Ladevorgangs optimale Verteilung sämtlicher Leitungen wird erhalten, wenn

- I im wesentlichen gleich N/(2·K) und
- J im wesentlichen gleich M/(2·L)

gewählt wird.

Bei vorgegebenem N, K, M und L können sich für I und J wegen der Divisionen Reste ergeben, die auf die zwischen den Potentialleitungen 7 liegenden Gruppen aus Bitleitungen 4, $4_1$ und/oder die zwischen den Vorladeleitungen 6 liegenden Gruppen aus Auswahlleitungen 5 verteilt werden müssen, so daß sich die Gesamtzahlen N und/oder M ergeben.

Die Beschleunigung B des Ladevorgangs läßt sich gegenüber dem Ausführungsbeispiel nach Figur 1, bei welchem nur zwei Potentialleitungen 7 außerhalb der Bitleitungen 4 und $4_1$ und eine einzige Vorladeleitung 6 in der Mitte des Feldes aus Speicherzellen 1 vorhanden sind, ist annähernd durch

$$B \approx L^2 . K^2$$

gegeben.

Demnach hängt die Beschleunigung des Ladevorganges quadratisch von der Anzahl L der Vorladeleitungen 6 und der Anzahl K der Potentialleitungen 7 ab. Beispielsweise ergibt sich bei L = 2 und K = 2 eine Beschleunigung um den Faktor 16 für die langsamsten Aufladepunkte, die in der Figur 2 durch schwarze Punkte 15 hervorgehoben sind.

Bei der erfindungsgemäßen Anordnung ist es in jedem Falle günstig, wenn sowohl die Potentialleitungen 7 als auch die Vorladeleitungen 6 niederohmig angeschlossen werden können.

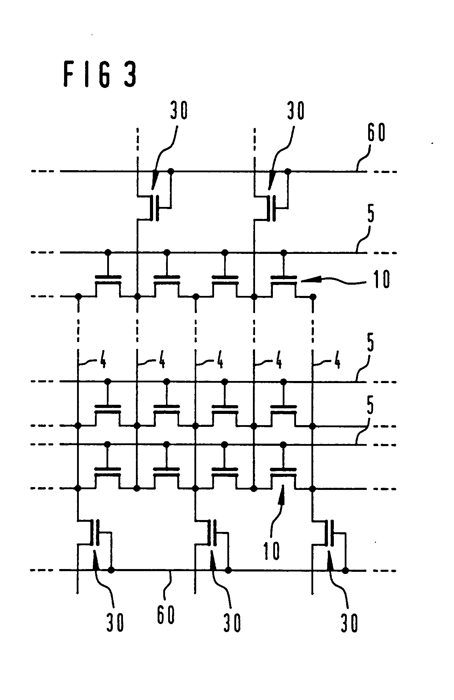

Die in der Figur 3 zum Vergleich dargestellte Speicheranordnung bisheriger Art weist nur die Bitleitungen 4, Auswahlleitungen 5 und die MOS-Transistoren 10 auf, deren Verschaltung wie bei der erfindungsgemäßen Anordnung ist. Von links nach rechts gezählt, weist jede zweite Bitleitung 4 an einem Ende, beispielsweise dem unteren Ende in Figur 3, je einen parallel geschalteten MOS-Transistor 30 auf, wobei die Gateanschlüsse dieser Transistoren 30 an eine gemeinsame Vorladeleitung 60 angeschlossen sind. Die restlichen Bitleitungen 4 weisen dagegen an ihren oberen Enden parallel geschaltete MOS-Transistoren 30 auf, deren Gateanschlüsse ebenfalls an eine gemeinsame Vorladeleitung 60 angeschlossen sind.

Würden die Transistoren 30 ausschließlich zum Vorladen benutzt, wäre der Zugang zu den Bitleitungen 4 für den Daten-transfer versperrt. Vorladen und Datentransfer gemeinsam kann bei einer Anordnung nach Figur 3 nur über eine komplizierte Schaltungsanordnung an den Enden der Bitleitungen 4 realisiert werden.

**Patentansprüche**

1. Speicherzellenanordnung aus matrixförmig in Zeilen (2) und Spalten (3) angeordneten Speicherzellen (1), deren jede einen MOS-Transistor (10) mit je einem Sourceanschluß ($10_1$), Drainanschluß ($10_2$) und Gateanschluß ($10_3$) aufweist, wobei

   - jede Spalte (3) zwischen zwei benachbarten Bitleitungen (4, 4; 4, $4_1$) angeordnet ist und
   - entlang jeder Zeile (2) je eine zugeordnete Auswahlleitung (5) verläuft, und wobei
   - jeder Transistor (10) einer Spalte (3) oder Zeile (2) über seinen Source- und Drainanschluß ($10_1$, $10_2$) an die beiden benachbarten Bitleitungen (4, 4; 4, $4_1$) und
   - jeder Transistor (10) einer Zeile (2) oder Spalte (3) über seinen Gateanschluß ($10_3$) an die zugeordnete Auswahlleitung (5)

   angeschlossen ist,
   **dadurch gekennzeichnet, daß**

   - jeweils zwischen zwei benachbarten Bitleitungen (4, 4; 4, $4_1$) und
   - zwischen zumindest einer bestimmten Bitleitung ($4_1$) und einem bestimmten elektrischen Potential (V)
   - je zumindest ein weiterer MOS-Transistor (20) mit je einem Sourceanschluß ($20_1$), Drainanschluß ($20_2$) und Gateanschluß ($20_3$) angeordnet ist,
   - der über seinen Sourceanschluß ($20_1$) und Drainanschluß ($20_2$) an die beiden benachbarten Bitleitungen (4, 4; 4, $4_1$) oder die bestimmte Bitleitung ($4_1$) und das bestimmte Potential (V) angeschlossen ist, und daß
   - die Gateanschlüsse ($20_3$) dieser weiteren MOS-Transistoren (20) an eine gemeinsame Vorladeleitung (6) zum wahlweisen Vorladen der Bitleitungen (4, $4_1$) auf das bestimmte Potential (V) angeschlossen sind.

2. Anordnung nach Anspruch 1,
   **dadurch gekennzeichnet,**
   **daß** zwei oder mehrere bestimmte Bitleitungen ($4_1$) vorgesehen sind, deren jede über den Source- und Drainanschluß ($20_1$, $20_2$) je eines mit seinem Gateanschluß ($20_3$) an die Vorladeleitung (6) angeschlossenen weiteren MOS-Transistors (20) an das bestimmte Potential (V) angeschlossen ist.

3. Anordnung nach Anspruch 1 oder 2,
   **gekennzeichnet durch**
   zwei oder mehrere Vorladeleitungen (6) zum wahlweisen Vorladen der Bitleitungen (4, $4_1$) auf das bestimmte Potential (V), an deren jede weiterer MOS-Transistoren (20) mit ihrem Gateanschluß ($20_3$) angeschlossen sind, deren jeder zwischen zwei benachbarten Bitleitungen (4, 4; 4, $4_1$) oder zumindest einer bestimmten Bitleitung ($4_1$) und dem bestimmten Potential (V) angeordnet und mit seinem Source- und Drainanschluß ($20_1$, $20_2$) an diese benachbarten Bitleitungen (4, 4; 4, $4_1$) oder diese bestimmte Bitleitung ($4_1$) und das bestimmte Potential (V) angeschlossen ist.

4. Anordnung nach einem der vorhergehenden Ansprüche,
   **dadurch gekennzeichnet,**
   **daß** das bestimmte Potential (V) an wenigstens einer Potentialleitung (7) anliegt, die neben zumindest einer bestimmten Bitleitung ($4_1$) verläuft.

5. Anordnung nach Anspruch 2, 3 und 4,
   **gekennzeichnet durch**

   - N Bitleitungen (4, $4_1$) und K Potentialleitungen (7), die in Zeilen- oder Spaltenrichtung nacheinander angeordnet sind, sowie
   - M Auswahlleitungen (5) und L Vorladeleitungen (6), die in Spalten- oder Zeilenrichtung nacheinander angeordnet sind, wobei
   - die K Potentialleitungen (7) unter den N Bitleitungen (4, $4_1$) und
   - L Vorladeleitungen (6) unter den M Auswahlleitungen (5) derart verteilt sind, daß
   - zwischen jeweils einem (81 oder 82) von zwei einander gegenüberliegenden und jeweils quer zu den Auswahlleitungen (5) verlaufenden äußeren Rändern (81, 82) der Anordnung und jeweils einer diesem Rand (81 bzw. 82) nächstliegenden äußersten der K Potentialleitungen (7)

- jeweils I Bitleitungen (4, $4_1$) und
- zwischen jeweils einem (91 oder 92) von zwei einander gegenüberliegenden und jeweils längs der Auswahlleitungen (5) verlaufenden äußeren Rändern (91, 92) der Anordnung und jeweils einer diesem Rand (91, 92) nächstliegenden äußersten der L Vorladeleitungen (6)
- jeweils J Auswahlleitungen (5)

liegen, wobei

- I im wesentlichen gleich N/(2·K) und
- J im wesentlichen gleich M/(2·L)

gewählt ist und N, M, K und L jeweils natürliche Zahlen bedeuten.

## Claims

1. Memory cell arrangement comprising memory cells (1) which are arranged in matrix form in rows (2) and columns (3) and each of which has a MOS-transistor (10) each having a source terminal ($10_1$), drain terminal ($10_2$) and gate terminal ($10_3$),

   - each column (3) being arranged between two adjacent bit lines (4,4;4,$4_1$) and
   - a respective assigned select line (5) running along each row (2), and
   - each transistor (10) of a column (3) or row (2) being connected via its source and drain terminals ($10_1$,$10_2$) to the two adjacent lines (4,4; 4,$4_1$) and
   - each transistor (10) of a row (2) or column (3) being connected via its gate terminal ($10_3$) to the assigned select line (5),

   **characterized in that**

   - in each case between two adjacent bit lines (4,4;4,$4_1$) and
   - between at least on specific bit line ($4_1$) and a specific electrical potential (V),
   - there is arranged in each case at least one further MOS-transistor (20) in each case having a source terminal ($20_1$), drain terminal ($20_2$) and gate terminal ($20_3$),
   - which is connected via its source terminal ($20_1$) and drain terminal ($20_2$) to the two adjacent bit lines (4,4;4,$4_1$) or the specific bit line ($4_1$) and the specific potential (V), and **in that**
   - the gate terminals ($20_3$) of the these further MOS-transistors (20) are connected to a common precharge line (6) for optionally precharging the bit line (4, $4_1$) to the specific potential (V).

2. Arrangement according to Claim 1,
   **characterized**
   **in that** two or more specific bit lines ($4_1$) are provided, each of which is connected to the specific potential (V) via the source and drain terminals ($20_1$, $20_2$) of a respective further MOS-transistor (20), which is connected to the precharge line (6) by its gate terminal ($20_3$).

3. Arrangement according to Claim 1 or 2,
   **characterized by**
   two or more precharge lines (6) for optionally precharging the bit lines (4,$4_1$) to the specific potential (V), to each of which further MOS-transistors (20) are connected by their gate terminal ($20_3$), each of which is arranged between two adjacent bit lines (4,4;4,$4_1$) or at least one specific bit line ($4_1$) and the specific potential (V) and is connected by its source and drain terminals ($20_1$,$20_2$) to the said adjacent bit lines (4,4;4,$4_1$) or the said specific bit line ($4_1$) and the specific potential (V).

4. Arrangement according to one of the preceding claims,
   **characterized**
   **in that** the specific potential (V) is present on at least one potential line (7) which runs beside at least one specific bit line ($4_1$).

5. Arrangement according to Claims 2, 3 and 4,
   **characterized by**

   - N bit lines (4,$4_1$) and K potential lines (7), which are arranged one after the other in the row or column direction, and
   - M select lines (5) and L precharge lines (6) which are arranged one after the other in the column or row direction,
   - the K potential lines (7) being distributed among the N bit lines (4,$4_1$) and
   - the L precharge lines (6) being distributed among the M select lines (5) in such a way that
   - between in each case one (81 or 82) of two outer edges (81,82) of the arrangement, the said edges being opposite one another and in each case running transversely with respect to the select lines (5), and in each case an outermost one of the K potential lines (7), which is nearest to the said edge (81 or 82),
   - there are situated in each case I bit lines (4,$4_1$), and
   - between in each case one (91 or 92) of two outer edges (91,92) of the arrangement, the said edges being opposite one another and in each case running along the select lines (5), and in each case an outermost one of the L precharge lines (6), which is nearest to the said edge (91,92),

- there are situated in each case J select lines (5), where
- I is chosen to be essentially equal to N/(2·K) and
- J is chosen to be essentially equal to M/(2·L)

and N,M,K and L each denote natural numbers.

## Revendications

1. Dispositif de cellules de mémoire constitué de cellules (1) de mémoire disposées sous forme de matrice en lignes (2) et en colonnes (3), dont chacune comporte un transistor (10) MOS ayant respectivement une borne ($10_1$) de source, une borne ($10_2$) de drain et une borne ($10_3$) de grille, dans lequel

   - chaque colonne (3) est disposée entre deux lignes (4, 4 ; 4, $4_1$) voisines de bits et
   - le long de chaque ligne (2) s'étend respectivement une ligne (5) de sélection associée et dans lequel
   - chaque transistor (10) d'une ligne (2) ou d'une colonne (3) est relié par sa borne ($10_1$, $10_2$) de source et de drain aux deux lignes (4, 4 ; 4, $4_1$) voisines de bits et
   - chaque transistor (10) d'une ligne (2) ou d'une colonne (3) est relié par sa borne ($10_3$) de grille à la ligne (5) de sélection associée

   **caractérisé en ce que**

   - il est prévu respectivement entre deux lignes (4, 4 ; 4, $4_1$) de bits voisines et
   - entre au moins une ligne ($4_1$) de bits déterminée et un potentiel (V) électrique déterminé
   - respectivement au moins un autre transistor (20) MOS ayant respectivement une borne ($20_1$) de source, une borne ($20_2$) de drain et une borne ($20_3$) de grille,
   - qui est raccordé par sa borne ($20_1$) de source et sa borne ($20_2$) de drain aux deux lignes (4, 4 ; 4, $4_1$) de bits voisines ou à la ligne ($4_1$) de bits déterminée et au potentiel (V) déterminé et **en ce que**
   - les bornes ($20_3$) de grille de ces autres transistors (20) MOS sont reliées à une ligne (6) commune de précharge pour précharger à volonté les lignes (4, $4_1$) de bits et les mettre au potentiel (V) déterminé.

2. Dispositif suivant la revendication 1,

   **caractérisé**

   **en ce qu'**il est prévu deux ou plusieurs lignes ($4_1$) de bits déterminées, dont chacune est reliée, par la borne ($20_1$, $20_2$) de source et de drain, de respectivement un autre transistor (20) MOS, relié par sa borne ($20_3$) de grille à la ligne (6) de précharge, au potentiel (V) déterminé.

3. Dispositif suivant la revendication 1 ou 2,

   **caractérisé**

   **en ce qu'**il est prévu deux ou plusieurs lignes (6) de précharge pour précharger au choix au potentiel (V) déterminé les lignes (4, $4_1$) de bits, auquel est raccordé chaque autre transistor (20) MOS par sa borne ($20_3$) de grille, chaque autre transistor étant disposé entre deux lignes (4, 4 ; 4, $4_1$) de bits voisines ou au moins une ligne ($4_1$) de bits déterminée et le potentiel (V) déterminé, et étant raccordé par sa borne ($20_1$, $20_2$) de source et de drain à ces lignes (4, 4 ; 4, $4_1$) de bits voisines ou à cette ligne ($4_1$) de bits déterminée et au potentiel (V) déterminé.

4. Dispositif suivant l'une des revendications précédentes,

   **caractérisé**

   **en ce que** le potentiel (V) déterminé s'applique à au moins une ligne (7) de potentiel qui s'étend à côté au moins d'une ligne ($4_1$) de bits déterminée.

5. Dispositif suivant la revendication 2, 3 et 4,

   **caractérisé par**

   - N lignes (4, $4_1$) de bits et K lignes (7) de potentiel, qui sont disposées les unes après les autres dans la direction des lignes ou des colonnes, ainsi que
   - M lignes (5) de sélection et L lignes (6) de précharge, qui sont disposées les unes à la suite des autres dans la direction des lignes ou des colonnes, dans lequel
   - les K lignes (7) de potentiel sont réparties entre les N lignes (4, $4_1$) de bits et
   - les L lignes (6) de précharge sont réparties entre les M lignes (5) de sélection, de façon que
   - il y ait entre respectivement l'un (81 ou 82) de deux bords (81, 82) extérieurs, opposés l'un à l'autre et s'étendant respectivement transversalement aux lignes (5) de sélection, du dispositif et respectivement l'une des K lignes (7) de potentiel la plus proche de ce bord (81 ou 82) et la plus à l'extérieur
   - respectivement I lignes (4, $4_1$) de bits et
   - entre respectivement l'un (91 ou 92) de deux bords (91, 92) extérieurs, opposés l'un à l'autre et s'étendant respectivement le long des lignes (5) de sélection, du dispositif et respectivement l'une des L lignes (6) de précharge la plus à l'extérieur et la plus proche de ce bord (91, 92), parmi les

- respectivement J lignes (5) de sélection
- I étant sensiblement égal à N/ (2· K) et
- J étant sensiblement égal à M/ (2· L)

et N, M, K et L sont respectivement des nombres naturels.

FIG 1

FIG 2

# FIG 3